# EUROPÄISCHE PATENTSCHRIFT

(11) **EP 3 464 216 B1**
(45) Veröffentlichungstag und Bekanntmachung des Hinweises auf die Patenterteilung: **04.11.2020**
(21) Anmeldenummer: 17735371.1
(22) Anmeldetag: 29.05.2017
(51) Int. Cl.: C04B 35/48, C21D 9/00, F27B 1/14, F27D 1/02

(54) **HOCHTEMPERATUR-ISOLIERSYSTEM**
HIGH-TEMPERATURE INSULATING SYSTEM
SYSTÈME D'ISOLATION HAUTE TEMPÉRATURE

(30) Priorität: 01.06.2016 AT 12216 U
(43) Veröffentlichungstag der Anmeldung: 10.04.2019
(73) Patentinhaber: Plansee SE, 6600 Reutte (AT)
(72) Erfinder: KLEINPASS, Bernd, 6600 Reutte (AT); MALLAUN, Peter, 6600 Reutte (AT); MARK, Michael, 6600 Reutte (AT); VALENTINI, Bernhard, 6600 Reutte (AT)
(74) Vertreter: Ciesla, Bettina
(86) Internationale Anmeldenummer: PCT/AT2017/000041
(87) Internationale Veröffentlichungsnummer: WO 2017/205882

(56) Entgegenhaltungen:
- WO-A1-2014/094009
- JP-A- H07 225 083
- JP-A- 2001 235 288

## Beschreibung

Die Erfindung betrifft ein Hochtemperatur-Isoliersystem mit den Merkmalen des Oberbegriffs von Anspruch 1.

Hochtemperatur-Isoliersysteme sind beispielsweise aus dem Industrieofenbau bekannt. Hochtemperatur-Isoliersysteme dienen dazu, einen Prozessraum und in dem oder um den Prozessraum angeordnete Heizvorrichtungen thermisch von einer Umgebung zu isolieren.

Insbesondere für Anwendungen unter Vakuum, bei welchen der bestimmende Anteil der Wärmeübertragung über Strahlung erfolgt, besteht ein Hochtemperatur-Isoliersystem üblicherweise aus einer sogenannten Strahlungsabschirmung, welche von im Wesentlichen parallel zueinander angeordneten und über Distanzierungsmittel voneinander beabstandet gehaltenen Strahlblechen aus Refraktärmetall, insbesondere Wolfram, Molybdän oder deren Legierungen gebildet ist.

Auch gibt es Bestrebungen, die Wirkung einer Strahlungsabschirmung mit Maßnahmen zur Reduktion von Wärmeleitung und / oder Konvektion zu kombinieren. So zeigt die AT13369U1 ein Hochtemperatur-Isoliersystem umfassend ein Abschirmelement, welches einen geschlossenen oder teilweise offenen Behälter aus Refraktärmetallblech aufweist, der einen in partikulärer und/oder faseriger Struktur vorliegenden keramischen Werkstoff auf der Basis von Zirconiumdioxid (ZrO₂) einschließt. Nachteilig an der Verwendung von Zirconiumdioxid ist dessen hohe Dichte und die geringe Formstabilität in der partikulären und / oder faserigen Struktur.

Ebenfalls bekannt sind Hochtemperatur-Isoliersysteme auf der Basis von Graphit. Die US2014261158 zeigt einen Ofen zur Zucht von Saphir-Einkristallen mit einer Isolierung aus Graphit.

Die JP2001235288 (A) zeigt eine Isolierung aus Kohlenstoff-basiertem Material mit einer daran fixierten Auskleidung.

Die Schwierigkeit mit der Verwendung von graphitischen Isolierungen liegt in einer möglichen Kontamination eines Wärmebehandlungsgutes durch Kohlenstoff.

Die bisher bekannten Ansätze zur Vermeidung einer Kontamination eines Wärmebehandlungsgutes durch aus einer graphitischen Isolierung und/oder von graphitischen Heizern herrührenden Kohlenstoff beruhen auf einer dichten Kapselung des Wärmebehandlungsgutes, beispielsweise durch ein das Wärmebehandlungsgut einschließendes Gefäß. Nachteilig an solchen zusätzlichen Kapselungen um das Wärmebehandlungsgut ist es, dass der Wärmeübergang von Heizvorrichtungen auf das Wärmebehandlungsgut beeinträchtigt wird.

Aufgabe der vorliegenden Anmeldung ist es, ein verbessertes Hochtemperatur-Isoliersystem anzugeben. Insbesondere soll eine Kontamination des Wärmebehandlungsgutes durch aus einem Bestandteil des Hochtemperatur-Isoliersystems stammenden Kohlenstoff verhindert werden.

Gelöst wird diese Aufgabe durch ein Hochtemperatur-Isoliersystem mit den Merkmalen von Anspruch 1. Bevorzugte Ausführungsformen sind in abhängigen Ansprüchen angegeben.

Das Hochtemperatur-Isoliersystem zur thermischen Isolierung eines Prozessraums eines Hochtemperaturofens gemäß der Erfindung weist mindestens zwei in einer Abschirmrichtung aufeinanderfolgende Isolierungslagen auf mit
- einer ersten Isolierungslage basierend auf Refraktärmetall,
- einer zweiten Isolierungslage aus einem Kohlenstoff-basierten Material, welche relativ zu der ersten Isolierungslage in vom Prozessraum abgewandter Richtung angeordnet ist,
wobei die erste Isolierungslage sich in eine Einfassung fortsetzt, welche die zweite Isolierungslage zumindest abschnittsweise in Abschirmrichtung umgreift.

Unter Prozessraum wird jener Raum des Hochtemperaturofens verstanden, in welchen ein Chargiergut eingebracht werden kann. Den Prozessraum umgeben in der Regel Heizvorrichtungen, die das Chargiergut erwärmen können. Das Hochtemperatur-Isoliersystem hat zur Aufgabe, den Prozessraum bzw. die den Prozessraum umgebenden Heizvorrichtungen thermisch von einer Umgebung zu isolieren.

Der Hochtemperaturofen umfasst weiters eine äußere Ofenwandung, die meist als Stahlmantel ausgeführt ist.

Vom Prozessraum zur äußeren Ofenwandung stellt sich im Betrieb des Hochtemperaturofens ein Temperaturgradient ein. Die Richtung vom Prozessraum zur äußeren Ofenwandung wird als Abschirmrichtung bezeichnet. Die erste Isolierungslage aus Refraktärmetall besteht beispielsweise aus einem Strahlblech aus Wolfram oder Molybdän. Es können weitere Strahlbleche, Beschichtungen und Anbauteile vorgesehen sein.

Unter Refraktärmetallen werden im Zusammenhang mit dieser Erfindung die Metalle der 4. Gruppe (Titan, Zirconium und Hafnium), der 5. Gruppe (Vanadium, Niob und Tantal) und der 6. Gruppe (Chrom, Molybdän und Wolfram) des Periodensystems sowie Rhenium und Legierungen der genannten Elemente (Refraktärmetalllegierungen) verstanden. Unter Refraktärmetalllegierungen sind Legierungen mit wenigstens 50 at. % des betreffenden Elements gemeint. Typisch für die erste Isolierungslage ist etwa ein Wolfram-Blech mit einer Stärke von beispielsweise 1-4 mm.

Die Isolierwirkung von Strahlblechen beruht auf der Abschirmung der Wärmestrahlung. In der Regel sind mehrere Strahlbleche parallel zueinander und voneinander beabstandet angeordnet. Abhängig von der erforderlichen Temperaturbeständigkeit kann das dem Prozessraum und damit den Heizvorrichtungen am nächsten liegende Strahlblech aus Wolfram, und die in Abschirmrichtung weiter außen angeordneten Strahlbleche aus Molybdän ausgebildet sein.

Die zweite Isolierungslage aus einem Kohlenstoff-basierten Material ist beispielsweise von einer oder mehreren Platten aus graphitischem Isolationsmaterial gebildet. Geeignet sind beispielsweise Platten aus Graphitfilz. Graphitfilze bestehen aus verpressten, häufig über ein Bindemittel gebundenen graphitierten Kohlenstofffasern. Graphitfilze weisen eine hohe Temperaturbeständigkeit bis etwa 2200°C und geringe Wärmeleitfähigkeit auf. Die Stärke der zweiten Isolierungslage kann beispielsweise 30-150 mm betragen.

Die zweite Isolierungslage ist relativ zu der ersten Isolierungslage in vom Prozessraum abgewandter Richtung angeordnet. In anderen Worten befindet sich die zweite Isolierungslage in Abschirmrichtung weiter außen.

Erfindungsgemäß ist vorgesehen, dass die erste Isolierungslage sich in eine Einfassung fortsetzt, welche die zweite Isolierungslage zumindest abschnittsweise in Abschirmrichtung umgreift.

Es kann vorgesehen sein, dass die Einfassung von der ersten Isolierungslage gebildet ist. Dies kann etwa durch eine Abkantung oder Bördelung der ersten Isolierungslage realisiert sein.

Es ist jedoch nicht zwingend, dass die Einfassung monolithisch, d.h. einstückig mit der ersten Isolierungslage ausgeführt ist. Die Einfassung kann auch durch eine separate Fortsetzung gebildet sein, welcher sich im Wesentlichen orthogonal von der ersten Isolierungslage fortsetzt und die zweite Isolierungslage zumindest abschnittsweise in Abschirmrichtung umgreift. Die Fortsetzung kann mit der ersten Isolierungslage verbunden sein oder auf diese aufgelegt sein.

Umgreifen heißt, dass die Einfassung die zweite Isolierungslage an deren Stirnseite(n) zumindest abschnittsweise bedeckt bzw. verschließt.

Besonders bevorzugt ist vorgesehen, dass die Einfassung umlaufend ausgebildet ist. Umlaufend heißt, dass die Einfassung umfänglich geschlossen ist. In anderen Worten sollen die Stirnseiten der zweiten Isolierungslage bevorzugt im Wesentlichen vollständig von der Einfassung bedeckt bzw. verschlossen sein.

Die Einfassung verhindert, dass Kohlenstoff aus der zweiten Isolierungslage in den Prozessraum übertreten kann. Bevorzugt ist die erste Isolierungslage so ausgeführt, dass diese die zweite Isolierungslage annähernd gasdicht vom Prozessraum trennt. Dazu ist die erste Lage vorzugsweise einteilig und fugenlos ausgebildet.

Bevorzugt ist vorgesehen, dass die Einfassung wenigstens eine Stirnseite der zweiten Isolierungslage zu mehr als 75%, vorzugsweise zu mehr als 90%, besonders bevorzugt vollständig bedeckt. Mit Stirnseiten der zweiten Isolierungslage sind die Schmalseiten gemeint, im Gegensatz zu den Mantelflächen. Die Ebenennormalen der Stirnseiten liegen in der Regel senkrecht zur Abschirmrichtung. Bei einer zylinderingförmigen Abschirmung sind die Stirnseiten die kreisringförmigen Deckflächen des Zylinderrings.

Bevorzugt ist vorgesehen, dass wobei die Einfassung die wenigstens eine Stirnseite der zweiten Isolierungslage flächig bedeckt. Die Einfassung kann geschlitzt sein, bevorzugt aber ist eine lückenlose Überdeckung der zweiten Isolierungslage in Abschirmrichtung.

Die zweite Isolierungslage ist durch die Einfassung gegenüber dem Prozessraum zumindest teilweise eingehaust. Durch die Einfassung wird sichergestellt, dass kein von der zweiten Lage kommender Kohlenstoff in Richtung Prozessraum gelangen kann. Dadurch wird ein im Prozessraum befindliches Chargiergut vor einer möglichen Kontamination durch Kohlenstoff bewahrt. Dies ist beispielsweise besonders relevant für die Herstellung von Saphir-Einkristallen. Hier führt eine Kontamination mit Kohlenstoff zu einer Entwertung des Saphir-Einkristalls.

Durch das erfindungsgemäße Hochtemperatur-Isoliersystem werden eine besonders günstige Isolierwirkung und dadurch ein geringer Energieverbrauch eines damit ausgestatteten Hochtemperaturofens erzielt.

Das erfindungsgemäße Hochtemperatur-Isoliersystem erlaubt den Einsatz von Graphit als Isolierung bei Anwendungen, in welchen eine Kontamination eines Chargiergutes mit Kohlenstoff zu vermeiden ist. Die Verwendung von Graphit in der Isolierung von Hochtemperaturöfen ist wirtschaftlich interessant, da Graphit robust und kostengünstiger als Voll-Metall-Isolierungen ist. Die Erfindung vereint die Vorteile einer reinen Ofenatmosphäre von voll-metallischen Isolierungen mit der günstigen Isolierwirkung und der Robustheit einer Graphit-Isolierung.

Das erfindungsgemäße Hochtemperatur-Isoliersystem ist insbesondere für Vakuum-Anwendungen geeignet. Besonders vorteilhaft ist die Verwendung des erfindungsgemäßen Hochtemperatur-Isoliersystem in Hochtemperaturöfen zur Herstellung von Saphir-Einkristallen oder Quarzglas.

Gegenüber der aus dem Stand der Technik bekannten Maßnahme zur Verhinderung einer Kontamination des Wärmebehandlungsgutes durch Einkapselung desselben ist der erfindungsgemäße Vorschlag besonders vorteilhaft, da durch die erfindungsgemäße Maßnahme überhaupt ein Übertritt von Kohlenstoff in den Prozessraum verhindert wird. Dies erlaubt beispielsweise auch die Verwendung metallischer Heizvorrichtungen, welche durch bisher bekannte Maßnahmen zur Verhinderung einer Kontamination des Wärmebehandlungsgutes durch Kohlenstoff nicht geschützt würden. Eine Exposition von metallischen Heizvorrichtungen (beispielsweise Heizleitern aus Wolfram) mit Kohlenstoff führt zur Bildung von Karbiden und in weiterer Konsequenz zu einer Zerstörung der metallischen Heizvorrichtungen.

Weiters vorteilhaft an der erfindungsgemäßen Maßnahme ist, dass keine Einkapselung des Wärmebehandlungsgutes vorgesehen werden muss. Wie oben ausgeführt, bewirkt der Verzicht auf eine Einkaspelung des Wärmebehandlungsgutes einen besseren Wärmeübergang von den Heizvorrichtungen auf das Wärmebehandlungsgut.

Die Einfassung bewirkt eine kontrollierte Führung eines im Hochtemperaturofen vorliegenden (Rest-)Gases bzw. Partikeln solchermaßen, dass das Gas bzw. die Partikel nicht aus der zweiten Isolierungslage in den Prozessraum treten, sondern in eine dem Prozessraum abgewandte Richtung abgelenkt werden. Das Gas bzw. die Partikel können in weiterer Folge von einer Vakuumpumpe abgesaugt werden oder schlagen sich an der kühleren Außenwandung des Hochtemperaturofens nieder.

Es kann vorgesehen sein, dass zwischen der ersten Isolierungslage und der zweiten Isolierungslage und / oder der ersten Isolierungslage und dem Prozessraum eine oder mehrere weitere Isolierungslagen angeordnet sind. Das bedeutet beispielsweise, dass weitere Strahlbleche zwischen der ersten Isolierungslage und der zweiten Isolierungslage und / oder zwischen der ersten Isolierungslage und dem Prozessraum ausgebildet sein können.

Die die Einfassung bildende bzw. sich in die Einfassung fortsetzende erste Isolierungslage muss also weder die dem Prozessraum nächste Isolierungslage noch die an die zweite Isolierungslage anschließende Isolierungslage bilden.

Erfindungsgemäß ist vorgesehen, dass die an die zweite Isolierungslage entgegen der Abschirmrichtung unmittelbar angrenzende Isolierungslage von der zweiten Isolierungslage beabstandet ist.

Durch den Abstand wird erreicht, dass die erste Isolierungslage aus Refraktärmetall nicht in direktem Kontakt mit der zweiten Lage aus einem Kohlenstoff-basierten Material steht. Bei direktem Kontakt von Refraktärmetall mit Kohlenstoff besteht bei erhöhten Temperaturen die Gefahr einer Karburierung des Refraktärmetalls und eine damit verbundene Versprödung des Refraktärmetalls. Ein Übertritt von Kohlenstoff aus der zweiten Isolierungslage auf die erste Isolierungslage kann auch zur unerwünschten Bildung niedrigschmelzender Phasen mit dem Refraktärmetall der ersten Isolierungslage führen.

Besonders vorteilhaft an der Beabstandung der an die zweite Isolierungslage entgegen der Abschirmrichtung (also in Richtung Prozessraum) unmittelbar angrenzende Isolierungslage ist die Schaffung eines Spalts zwischen der zweiten Isolierungslage und der entgegen der Abschirmrichtung daran unmittelbar angrenzenden Isolierungslage.

Dieser Spalt bewirkt, dass Kohlenstoff aus der zweiten Isolierungslage nicht durch Kontakt mit der ersten Isolierungslage in Richtung Prozessraum diffundieren kann, und dass Kohlenstoff gezielt in vom Prozessraum abgewandter Richtung abströmen kann.

Der Abstand wird durch Distanzierungsmittel realisiert. Die Distanzierungsmittel können beispielsweise durch Distanzhülsen gebildet sein.

Es kann vorgesehen sein, dass an der dem Prozessraum abgewandten Seite der zweiten Isolierungslage eine Deckschicht aus Metall oder einem Kohlenstoff-basierten Material ausgebildet ist. Die zweite Isolierungslage kann also an ihrer in Abschirmrichtung äußeren Seite abgedichtet sein. In anderen Worten kann vorgesehen sein, dass die zweite Isolierungslage an der dem Prozessraum abgewandten Seite durch eine Deckschicht, beispielsweise ein Blech aus (Refraktär)metall oder eine Kohlenstoff-basierte Platte, abgeschlossen ist. Die Deckschicht kann beispielsweise auch von einer metallischen Beschichtung oder Folie gebildet sein.

In diesem Fall ist die zweite Isolierungslage also zumindest zweiseitig geschlossen.

Betrachtet man das Beispiel eines Hochtemperatur-Isoliersystems mit zylindrischer Grundform in einer vertikalen Einbaulage, ist die Kohlenstoff-basierte zweite Isolierlage an ihrer inneren Mantelfläche von Refraktärmetallblech und an ihrer äußeren Mantelfläche von Metallblech und / oder einer Kohlenstoff-basierten Deckschicht umschlossen.

Darüber hinaus besteht noch die Einfassung, welche die zweite Lage zumindest abschnittsweise in vom Prozessraum abgewandter Richtung umgreift. Somit ist die Kohlenstoff-basierte zweite Isolierlage an ihren Mantelflächen und zumindest an einer ihrer Stirnflächen (durch die Einfassung) eingehaust.

Bevorzugt ist die Einfassung an der bezüglich der Vertikalen oberen Stirnfläche der zweiten Isolierlage ausgebildet.

Bevorzugt ist vorgesehen, dass die Einfassung und / oder die Deckschicht an der dem Prozessraum abgewandten Seite der zweiten Isolierungslage wenigstens eine Öffnung aufweist. Die Öffnung kann beispielsweise dadurch realisiert sein, dass die zweite Isolierungslage gegenüber der Außenwandung des Hochtemperaturofens offen ist, d.h. keine Deckschicht aufweist. Die Öffnung kann auch dadurch realisiert sein, dass zwischen der Einfassung und der zweiten Isolierungslage ein Abstand besteht und die Einfassung und die Deckschicht einen Schlitz oder Spalt bilden, durch den etwaiger Kohlenstoff und / oder Gas in vom Prozessraum abgewandter Richtung abströmen kann.

Auch können an der Deckschicht Perforationen ausgebildet sein, durch welche etwaige gasförmige oder partikuläre Bestandteile entweichen können.

Es können auch Kombinationen der Varianten von Öffnungen realisiert sein. Die Ausbildung wenigstens einer Öffnung bewirkt eine weiter verbesserte Führung von gasförmigen oder partikulären Bestandteilen der zweiten Isolierungslage solchermaßen, dass diese über die Öffnung an die dem Prozessraum abgewandte Seite der zweiten Isolierungslage gelenkt werden. Dort können die gasförmigen oder partikulären Bestandteile von einer gegebenenfalls vorhandenen Vakuumpumpe abgezogen werden.

Durch Auftrieb stellt sich eine bevorzugte Bewegungsrichtung der gasförmigen oder partikulären Bestandteile in Richtung der dem Prozessraum abgewandten Seite ein.

Besonders bevorzugt ist vorgesehen, dass die wenigstens eine Öffnung an einer bezüglich einer Einbaulage des Hochtemperatur-Isoliersystems oben und / oder in einer in Abschirmrichtung außen gelegenen Position ausgebildet ist. Durch die Positionierung "oben" kann die durch Auftrieb bewirkte Bewegungsrichtung der gasförmigen oder partikulären Bestandteile vorteilhaft genutzt werden, da die Strömung in Richtung oben gelegener Positionen erfolgt und somit die gasförmigen oder partikulären Bestandteile selbsttätig aus der Öffnung abströmen.

Bei jenen Abschnitten des Hochtemperatur-Isoliersystems, welche eine Bodenisolierung des Hochtemperaturofens bilden, sind die Öffnungen vorteilhaft nicht "oben", jedoch in Abschirmrichtung außen angeordnet.

Durch die Einfassung und - besonders bevorzugt - durch die Öffnung(en) gelingt es, gegebenenfalls vorhandene Verunreinigungen vom Prozessraum fernzuhalten und aus dem Hochtemperaturofen abzuführen.

Bevorzugt ist vorgesehen, dass das Hochtemperatur-Isoliersystem den Prozessraum in Form eines geschlossenen Hohlzylinders oder eines polygonalen Prismas umschließt. Bevorzugt ist der Prozessraum also zumindest mantelseitig vollständig vom Hochtemperatur-Isoliersystem umgeben.

Schutz wird auch begehrt für einen Hochtemperaturofen mit einem Hochtemperatur-Isoliersystem nach wenigstens einem der Ansprüche. Besonders bevorzugt handelt es sich um einen Hochtemperaturofen zur Herstellung von Saphir-Einkristall oder Quarzglas.

Bevorzugt ist vorgesehen, dass an der Außenwandung des Hochtemperatur-Ofens wenigstens eine Bohrung vorgesehen ist, welche Bohrung mit einer Vakuumpumpe verbindbar ist und die Bohrung benachbart zur Öffnung angeordnet ist. Der Hochtemperatur-Ofen kann durch die Vakuumpumpe evakuiert werden oder es können zumindest gasförmige oder partikuläre Bestandteile einer Atmosphäre des Hochtemperatur-Ofens durch die Vakuumpumpe abgezogen werden. Durch die benachbarte Anordnung der Bohrung und der Öffnung wird erreicht, dass aus der zweiten Isolierungslage stammende gasförmige oder partikuläre Bestandteile auf direktem Weg abgezogen werden.

Die Erfindung wird anhand der folgenden Figuren näher erläutert.

Dabei zeigt:
- Fig. 1: ein Hochtemperatur-Isoliersystem der Erfindung in einem ersten Ausführungsbeispiel im Querschnitt
- Fig. 2: ein Hochtemperatur-Isoliersystem der Erfindung in einem weiteren Ausführungsbeispiel
- Fig. 3: ein Detail des Hochtemperatur-Isoliersystems
- Fig. 4: Hochtemperatur-Isoliersystem der Erfindung in einem weiteren Ausführungsbeispiel im Querschnitt
- Fig. 5: Hochtemperatur-Isoliersystem der Figur 4 in einer Draufsicht

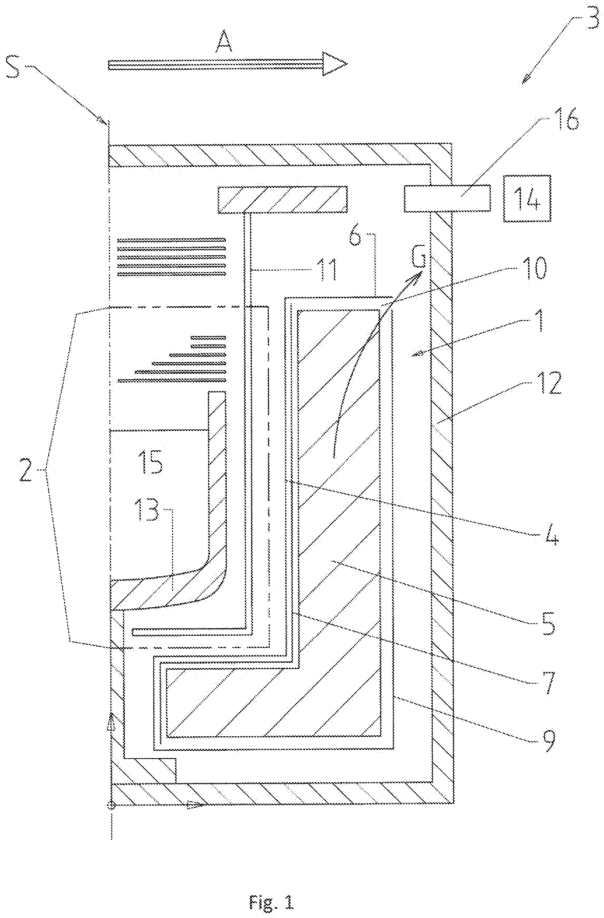

Figur 1 zeigt einen Ausschnitt eines Hochtemperaturofens 3 mit einem Hochtemperatur-Isoliersystem 1 der Erfindung in einem ersten Ausführungsbeispiel im Querschnitt. Da in diesem Beispiel das Hochtemperatur-Isoliersystem 1 rotationssymmetrisch um eine Symmetrieachse S ist, ist lediglich die rechte Schnitthälfte dargestellt. Das Hochtemperatur-Isoliersystem 1 hat in diesem Ausführungsbeispiel die Gestalt eines Hohlzylinders mit einem im Wesentlichen zylindrischen Boden.

Der Hochtemperaturofen 3 weist einen Prozessraum 2 auf, der von dem Hochtemperatur-Isoliersystem 1 an seinem Umfang und Boden umgeben ist. Der Prozessraum 2 ist von einer Heizvorrichtung 11 beheizbar. Vom Prozessraum 2 zu einer äußeren Ofenwandung 12 stellt sich im Betrieb des Hochtemperaturofens 3 ein Temperaturgradient ein. Die Richtung vom Prozessraum 2 zur äußeren Ofenwandung 12 wird als Abschirmrichtung A bezeichnet. Die Abschirmrichtung A ist über einen Blockpfeil eingezeichnet. Am Boden des Hochtemperatur-Isoliersystems 1 besteht eine Durchführung, durch welche eine Konsole geführt ist. Auf der Konsole ruht ein Tiegel 13. Der Tiegel 13 kann mit einem Chargiergut 15, beispielsweise Aluminiumoxid zur Herstellung von Saphir-Einkristallen, beladen werden.

Das Hochtemperatur-Isoliersystem 1 des vorliegenden Ausführungsbeispiels weist eine erste Isolierungslage 4 auf, die hier als Strahlblech aus Wolfram ausgeführt ist. Das Hochtemperatur-Isoliersystem 1 weist weiters eine zweite Isolierungslage 5 aus einem Kohlenstoff-basierten Material auf, welche relativ zu der ersten Isolierungslage 4 in vom Prozessraum 2 abgewandter Richtung angeordnet ist. Das Kohlenstoff-basierte Material kann beispielsweise ein Graphitfilz sein. Darüber hinaus ist eine Deckschicht 9 auf der dem Prozessraum 2 abgewandten Seite der zweiten Isolierungslage 5 vorgesehen.

Die Deckschicht 9 kann zum Beispiel von einem Blech, z. B. aus Refraktärmetall, oder einer Kohlenstoff-basierten Platte gebildet sein.

Die erste Isolierungslage 4 ist an ihrer Oberseite in Abschirmrichtung A abgekantet und bildet auf diese Weise eine (stirnseitige) Einfassung 6, welche die zweite Isolierungslage 5 an ihrer oberen Stirnseite zumindest abschnittsweise in Abschirmrichtung A umgreift.

Die Einfassung 6 verhindert, dass Kohlenstoff aus der zweiten Isolierungslage 5 in den Prozessraum 2 übertreten kann. Bevorzugt ist die erste Isolierungslage 4 so ausgeführt, dass diese die zweite Isolierungslage 5 gasdicht vom Prozessraum trennt. Dazu ist die erste Isolierungslage 4 vorzugsweise einteilig und fugenlos ausgebildet.

Zwischen der Einfassung 6 und der zweiten Isolierungslage 5 ist vorzugsweise auf der vom Prozessraum 2 abgewandten Seite eine Öffnung 10 vorgesehen, über welche gegebenenfalls gasförmige oder partikuläre Bestandteile der zweiten Isolierungslage 5 aus dieser gerichtet entweichen können. Durch Auftrieb ergibt sich eine bevorzugte Strömungsrichtung Gasströmung G von gasförmigen oder partikulären Bestandteilen. Die Strömungsrichtung wird von der Einfassung 6 zusätzlich gelenkt. Die Strömungsrichtung der Gasströmung G ist durch einen Pfeil illustriert.

Der Hochtemperaturofen 3 kann mit einer Vakuumpumpe 14 ausgestattet sein, welche Gas über eine Bohrung 16 aus dem Hochtemperaturofen 3 abziehen kann. Bevorzugt ist die Bohrung 16 in der Ofenwandung 12 zur Öffnung 10 benachbart angeordnet. So können partikuläre oder gasförmige Bestandteile der zweiten Isolierungslage 5 auf direktem Weg aus dem Hochtemperaturofen 3 abgeführt werden.

Das Hochtemperatur-Isoliersystem 1 kann auch andere Geometrien als die hier gezeigte zylindrische Grundform annehmen. Beispielsweise ist es möglich, eine umfangsseitige Isolierung in Form ebener Abschnitte abzubilden, sodass das Hochtemperatur-Isoliersystem 1 im Grundriss eine polygonale Form, z.B. rechteckige Form aufweist.

Der besondere Vorteil des Hochtemperatur-Isoliersystems 1 der Erfindung ist die Reinhaltung der Atmosphäre im Prozessraum 2.

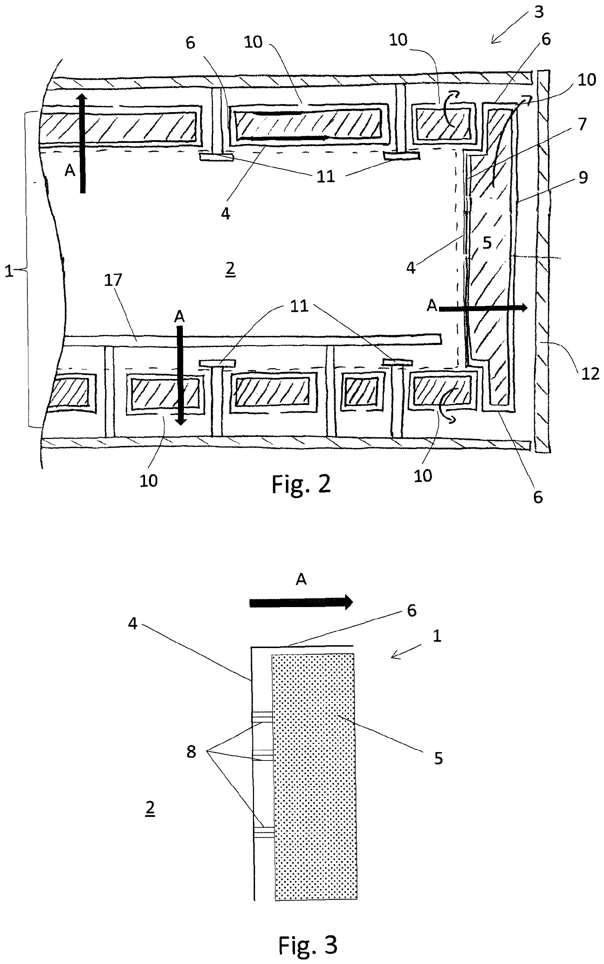

Figur 2 zeigt schematisch ein Hochtemperatur-Isoliersystem 1 eines Hochtemperaturofens 3 in horizontaler Bauweise. In diesem Ausführungsbeispiel wird der Prozessraum 2 horizontal beladen. Ein Chargenträger 17 kann mit einem Chargiergut 15 (nicht gezeigt) beladen werden. Die Beschaffenheit der Isolierungslagen ist analog zu dem Ausführungsbeispiel gemäß Figur 1.

Wie im Ausführungsbeispiel der Figur 1 bildet auch hier die erste Isolierungslage 4 eine Einfassung 6, welche die zweite Isolierungslage 5 zumindest abschnittsweise in Abschirmrichtung A umgreift. Damit wird verhindert, dass Kohlenstoff aus der Kohlenstoff-haltigen zweiten Isolierungslage 5 in den Prozessraum 2 gelangt.

Der am rechten Bildrand gezeigte Abschnitt des Hochtemperatur-Isoliersystems 1 ist als Türe ausgeführt, die zur Beladung des Hochtemperaturofens 3 abnehmbar oder schwenkbar ist.

Die Öffnungen 10 sind bezüglich der Einbaulage des Hochtemperatur-Isoliersystems 1 oben und / oder in einer in Abschirmrichtung A außen gelegenen Position ausgebildet. Durch die Positionierung "oben" kann die durch Auftrieb bewirkte Bewegungsrichtung der gasförmigen oder partikulären Bestandteile vorteilhaft genutzt werden, da die Strömung in Richtung oben gelegener Positionen erfolgt und somit die gasförmigen oder partikulären Bestandteile selbsttätig aus den Öffnungen 10 abströmen. Bei jenen Abschnitten des Hochtemperatur-Isoliersystems 1, welche die Bodenisolierung des Hochtemperaturofens 3 bilden, sind die Öffnungen 10 vorteilhaft nicht "oben", jedoch in Abschirmrichtung A außen gelegen.

Figur 3 zeigt ein Detail eines erfindungsgemäßen Hochtemperatur-Isoliersystems 1. Zwischen der ersten Isolierungslage 4 und der zweiten Isolierungslage 5 sind Distanzierungsmittel 8 vorgesehen, welche die erste Isolierungslage 4 aus Refraktärmetall von der Kohlenstoff-basierten zweiten Isolierungslage 5 trennen. Die Distanzierungsmittel 8 verhindern eine Karburierung des Refraktärmetalls. Dadurch wird die Lebensdauer der ersten Isolierungslage 4 erhöht und zudem eine Diffusion von Kohlenstoff in den Prozessraum 2 reduziert.

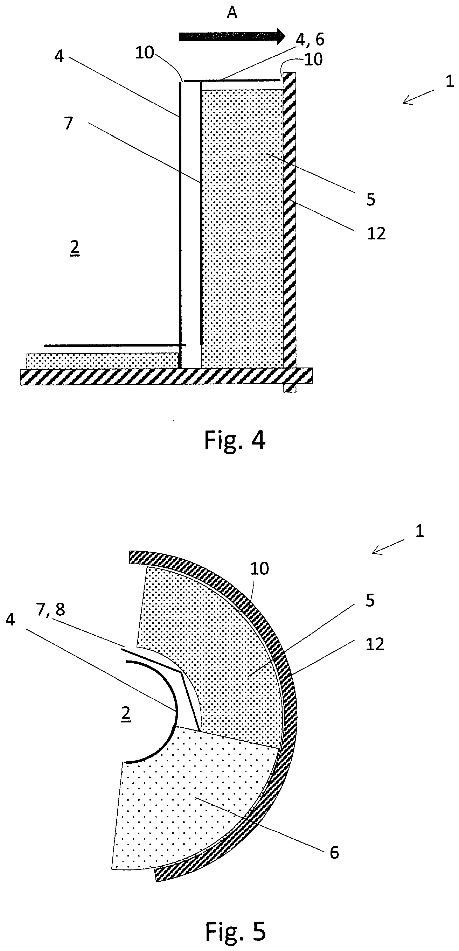

Figur 4 zeigt ein Hochtemperatur-Isoliersystem 1 der Erfindung in einem weiteren Ausführungsbeispiel im Querschnitt. Die Einfassung 6 ist in diesem Fall durch eine Art Deckel aus einem Refraktärmetall gebildet, welcher die zylinderringförmige zweite Isolierungslage 5 an ihrer Stirnseite bedeckt.

Figur 5 zeigt schematisch den Aufbau des Hochtemperatur-Isoliersystems 1 von Figur 4 in einer Draufsicht. Gezeigt ist ein Segment eines im Grundriss im Wesentlichen kreisförmigen Hochtemperatur-Isoliersystems 1, wobei die Einfassung 6 teilweise ausgeblendet ist, um die zweite Isolierungslage 5 erkennbar zu machen.

Die erste Isolierungslage 4 besteht in diesem Fall aus einem zylindrischen Strahlblech. Die Einfassung 6 ist von Kreisring-Segmenten aus Refraktärmetallblech gebildet, welche die zweite Isolierungslage 5 an ihrer Stirnseite bedecken bzw. verschließen. Die Kreisring-Segmente werden vorzugsweise überlappend angebracht. Der Übersichtlichkeit halber ist nur ein Segment davon gezeigt.

In Abschirmrichtung A außen liegt eine Außenwandung 12 aus Stahl.

Die weitere Isolierungslage 7 ist in diesem Ausführungsbeispiel durch ein polygonal gekantetes Blech gebildet, welches neben einer Wirkung als Strahlblech auch die erste Isolierungslage 4 von der Kohlenstoff-haltigen zweiten Isolierungslage 5 beabstandet. Die weitere Isolierungslage 7 wirkt in diesem Fall also auch als Distanzierungsmittel 8.

Durch die Erfindung wird ein hochreiner Prozessraum 2 ohne Kontamination durch Kohlenstoff bei gleichzeitiger Ausnutzung der Vorteile einer graphitischen Isolierung realisiert.

### Liste der verwendeten Bezugszeichen:

- 1: Hochtemperatur-Isoliersystem
- 2: Prozessraum
- 3: Hochtemperaturofen
- 4: erste Isolierungslage
- 5: zweite Isolierungslage
- 6: Einfassung
- 7: weitere Isolierungslage(n)
- 8: Distanzierungsmittel
- 9: Deckschicht
- 10: Öffnung
- 11: Heizvorrichtung
- 12: Außenwandung
- 13: Tiegel
- 14: Vakuumpumpe
- 15: Chargiergut
- 16: Bohrung
- 17: Chargenträger

## Patentansprüche

1. Hochtemperatur-Isoliersystem (1) zur thermischen Isolierung eines Prozessraums (2) eines Hochtemperaturofens (3), welches mindestens zwei in einer Abschirmrichtung (A) aufeinanderfolgende Isolierungslagen (4, 5) aufweist, mit
- einer ersten Isolierungslage (4) basierend auf Refraktärmetall,
- einer zweiten Isolierungslage (5) aus einem Kohlenstoff-basierten Material, welche relativ zu der ersten Isolierungslage (4) in vom Prozessraum (2) abgewandter Richtung angeordnet ist,
wobei
die erste Isolierungslage (4) sich in eine Einfassung (6) fortsetzt, welche die zweite Isolierungslage (5) zumindest abschnittsweise in Abschirmrichtung (A) umgreift, **dadurch gekennzeichnet, dass** die an die zweite Isolierungslage (5) entgegen der Abschirmrichtung unmittelbar angrenzende Isolierungslage (4, 7) durch Distanzierungsmittel (8) von der zweiten Isolierungslage (5) beabstandet ist..

2. Hochtemperatur-Isoliersystem (1) nach Anspruch 1, wobei die Einfassung (6) von der ersten Isolierungslage (4) gebildet ist.

3. Hochtemperatur-Isoliersystem (1) nach Anspruch 1, wobei die Einfassung (6) separat von der ersten Isolierungslage (4) gebildet ist.

4. Hochtemperatur-Isoliersystem (1) nach einem der Ansprüche 1 bis 3, wobei die Einfassung (6) umlaufend ausgebildet ist.

5. Hochtemperatur-Isoliersystem (1) nach einem der Ansprüche 1 bis 4, wobei die Einfassung (6) wenigstens eine Stirnseite der zweiten Isolierungslage (5) zu mehr als 75% bedeckt.

6. Hochtemperatur-Isoliersystem (1) nach einem der Ansprüche 1 bis 5, wobei die Einfassung (6) wenigstens eine Stirnseite der zweiten Isolierungslage (5) flächig bedeckt.

7. Hochtemperatur-Isoliersystem (1) nach einem der Ansprüche 1 bis 6, wobei die erste Isolierungslage (4) aus Bleche(n) gebildet ist.

8. Hochtemperatur-Isoliersystem (1) nach einem der Ansprüche 1 bis 7, wobei die zweite Isolierungslage (5) von einer oder mehreren Graphitbasierten Platten gebildet ist.

9. Hochtemperatur-Isoliersystem (1) nach einem der Ansprüche 1 bis 8, wobei zwischen der ersten Isolierungslage (4) und der zweiten Isolierungslage (5) und / oder der ersten Isolierungslage (4) und dem Prozessraum (2) eine oder mehrere weitere Isolierungslagen (7) angeordnet sind.

10. Hochtemperatur-Isoliersystem (1) nach einem der Ansprüche 1 bis 9, wobei an der dem Prozessraum (2) abgewandten Seite der zweiten Isolierungslage (5) eine Deckschicht (9) aus einem Metall oder einem Kohlenstoff-basierten Material ausgebildet ist.

11. Hochtemperatur-Isoliersystem (1) nach einem der Ansprüche 1 bis 10, wobei die Einfassung (6) und / oder die Deckschicht (9) an der dem Prozessraum (2) abgewandten Seite der zweiten Isolierungslage (5) wenigstens eine Öffnung (10) aufweist.

12. Hochtemperatur-Isoliersystem (1) nach Anspruch 11, wobei die Öffnung (10) an einer in Einbaulage des Hochtemperatur-Isoliersystems (1) oben und / oder in einer in Abschirmrichtung (A) außen gelegenen Position ausgebildet ist.

13. Hochtemperatur-Isoliersystem (1) nach einem der Ansprüche 1 bis 12, wobei das Hochtemperatur-Isoliersystem (1) den Prozessraum (2) in Form eines geschlossenen Hohlzylinders oder eines polygonalen Prismas umschließt.

14. Hochtemperatur-Ofen (3) mit einem Hochtemperatur-Isoliersystem (1) nach einem der Ansprüche 1 bis 13.

15. Hochtemperatur-Ofen (3) nach Anspruch 14, wobei an einer Außenwandung (12) des Hochtemperatur-Ofens (3) wenigstens eine Bohrung (16) vorgesehen ist, welche Bohrung (16) mit einer Vakuumpumpe (14) verbindbar ist und die Bohrung (16) benachbart zur Öffnung (10) angeordnet ist.

## Claims

1. High-temperature insulating system (1) for thermally insulating a process space (2) of a high-temperature furnace (3), which has at least two insulating layers (4, 5) which follow one another in a shielding direction (A), comprising
- a first insulating layer (4) based on refractory metal,
- a second insulating layer (5) composed of a carbon-based material which is arranged in the direction facing away from the process space (2) relative to the first insulating layer (4),
where
the first insulating layer (4) continues into a surround (6) which surrounds the second insulating layer (5) at least in sections in the shielding direction (A), **characterized in that** the insulating layer (4, 7) directly adjoining the second insulating layer (5) in a direction opposite to the shielding direction is kept at a distance from the second insulating layer (5) by spacers (8).

2. High-temperature insulating system (1) according to Claim 1, wherein the surround (6) is formed by the first insulating layer (4).

3. High-temperature insulating system (1) according to Claim 1, wherein the surround (6) is formed separately from the first insulating layer (4).

4. High-temperature insulating system (1) according to any of Claims 1 to 3, wherein the surround (6) is formed circumferentially.

5. High-temperature insulating system (1) according to any of Claims 1 to 4, wherein the surround (6) covers at least one end face of the second insulating layer (5) to an extent of more than 75%.

6. High-temperature insulating system (1) according to any of Claims 1 to 5, wherein the surround (6) covers the full area of at least one end face of the second insulating layer (5).

7. High-temperature insulating system (1) according to any of Claims 1 to 6, wherein the first insulating layer (4) is formed of metal sheet(s).

8. High-temperature insulating system (1) according to any of Claims 1 to 7, wherein the second insulating layer (5) is formed by one or more graphite-based plates.

9. High-temperature insulating system (1) according to any of Claims 1 to 8, wherein one or more further insulating layers (7) are arranged between the first insulating layer (4) and the second insulating layer (5) and/or the first insulating layer (4) and the process space (2).

10. High-temperature insulating system (1) according to any of Claims 1 to 9, wherein a covering layer (9) composed of a metal or carbon-based material is formed on the side of the second insulating layer (5) facing away from the process space (2).

11. High-temperature insulating system (1) according to any of Claims 1 to 10, wherein the surround (6) and/or the covering layer (9) has at least one opening (10) on the side of the second insulating layer (5) facing away from the process space (2).

12. High-temperature insulating system (1) according to Claim 11, wherein the opening (10) is formed at a position at the top in the installation orientation of the high-temperature insulating system (1) and/or in a position located at the outside in the shielding direction (A).

13. High-temperature insulating system (1) according to any of Claims 1 to 12, wherein the high-temperature insulating system (1) encloses the process space (2) in the form of a closed hollow cylinder or a polygonal prism.

14. High-temperature furnace (3) having a high-temperature insulating system (1) according to any of Claims 1 to 13.

15. High-temperature furnace (3) according to Claim 14, wherein at least one hole (16) is provided in an outer wall (12) of the high-temperature furnace (3), which hole (16) can be connected to a vacuum pump (14) and the hole (16) is arranged adjacent to the opening (10).

## Revendications

1. Système d'isolation pour haute température (1) destiné à l'isolation thermique d'au moins une chambre de processus (2) d'un four à haute température (3), lequel possède au moins deux couches d'isolation (4, 5) successives dans une direction de protection (A), comprenant
- une première couche d'isolation (4) basée sur un métal réfractaire,
- une deuxième couche d'isolation (5) en un matériau à base de carbone, lequel est disposé dans la direction opposée à la chambre de processus (2) par rapport à la première couche d'isolation (4),
la première couche d'isolation (4) se poursuivant dans un encadrement (6) qui enveloppe la deuxième couche d'isolation (5) au moins par certaines portions dans la direction de protection (A), **caractérisé en ce que** la couche d'isolation (4, 7) directement adjacente à la deuxième couche d'isolation (5) à l'opposé de la direction de protection est espacée de la deuxième couche d'isolation (5) par des moyens de distanciation (8).

2. Système d'isolation pour haute température (1) selon la revendication 1, l'encadrement (6) étant formé par la première couche d'isolation (4).

3. Système d'isolation pour haute température (1) selon la revendication 1, l'encadrement (6) étant formé séparément de la première couche d'isolation (4).

4. Système d'isolation pour haute température (1) selon l'une des revendications 1 à 3, l'encadrement (6) étant formé de manière périphérique.

5. Système d'isolation pour haute température (1) selon l'une des revendications 1 à 4, l'encadrement (6) recouvrant à plus de 75 % au moins un côté frontal de la deuxième couche d'isolation (5).

6. Système d'isolation pour haute température (1) selon l'une des revendications 1 à 5, l'encadrement (6) recouvrant en plan au moins un côté frontal de la deuxième couche d'isolation (5).

7. Système d'isolation pour haute température (1) selon l'une des revendications 1 à 6, la première couche d'isolation (4) étant formée de tôle(s).

8. Système d'isolation pour haute température (1) selon l'une des revendications 1 à 7, la deuxième couche d'isolation (5) étant formée d'une ou plusieurs plaques à base de graphite.

9. Système d'isolation pour haute température (1) selon l'une des revendications 1 à 8, une ou plusieurs couches d'isolation supplémentaires (7) étant disposées entre la première couche d'isolation (4) et la deuxième couche d'isolation (5) et/ou la première couche d'isolation (4) et la chambre de processus (2).

10. Système d'isolation pour haute température (1) selon l'une des revendications 1 à 9, une couche de recouvrement (9) en un métal ou un matériau à base de carbone étant formée au niveau du côté de la deuxième couche d'isolation (5) à l'opposé de la chambre de processus (2).

11. Système d'isolation pour haute température (1) selon l'une des revendications 1 à 10, l'encadrement (6) et/ou la couche de recouvrement (9) possédant au moins une ouverture (10) au niveau du côté de la deuxième couche d'isolation (5) à l'opposé de la chambre de processus (2) .

12. Système d'isolation pour haute température (1) selon la revendication 11, l'ouverture (10) étant, dans la position de montage du système d'isolation pour haute température (1), formée en haut et/ou dans une position située à l'extérieur dans la direction de protection (A).

13. Système d'isolation pour haute température (1) selon l'une des revendications 1 à 2, le système d'isolation pour haute température (1) enveloppant la chambre de processus (2) sous la forme d'un cylindre creux fermé ou d'un prisme polygonal.

14. Four à haute température (3) comprenant un système d'isolation pour haute température (1) selon l'une des revendications 1 à 13.

15. Four à haute température (3) selon la revendication 14, au moins un orifice (16) se trouvant au niveau d'une paroi externe (12) du four à haute température (3), ledit orifice (16) pouvant être relié à une pompe à vide (14) et l'orifice (16) étant disposé à côté de l'ouverture (10) .
